# EUROPEAN PATENT APPLICATION

(11) **EP 1 951 013 A2**
(43) Date of publication of application: **30.07.2008**
(21) Application number: 08100444.2
(22) Date of filing: 14.01.2008
(51) Int. Cl.: H05K 3/30, H05K 3/34

(54) **Connector applied underfill**

(30) Priority: 24.01.2007 US 657260
(71) Applicant: Delphi Technologies, Inc., Troy, Michigan 48007 (US)
(72) Inventor: Brandenburg, Scott D., Kokomo, IN 46902 (US); Delheimer, Charles I., Noblesville, IN 46060 (US)
(74) Representative: Denton, Michael John

(57) **Abstract**

Processes for reliably and durably mounting a connector body to a surface of a circuit board without using conventional underfill and overmolding techniques are provided. These processes involve preparation of a self adhering connector subassembly (30) comprising a connector body (12) and an activatable solid adhesive (24) disposed on a mounting surface (32) of the connector body (12), positioning of the subassembly (30) on a circuit board, and activation of the adhesive (24) to securely attach the connector body (12) to the circuit board. The activable solid adhesive (24) has a pattern of openings in which the solder balls (18) project.

## Description

### Technical Field

This invention relates to surface mount connectors, processes for preparing surface mounted connectors, and subassemblies for preparing surface mounted connectors. More particularly, the invention pertains to processes and subassemblies that facilitate a reliable and durable attachment of a connector body to the surface of a circuit board.

### Background of the Invention

The commercial use of surface mount connectors for electrically connecting an electrical device to a circuit substrate has been avoided due to unacceptable reliability. In particular, surface mount connectors used for automotive electronics have exhibited unacceptably high failure rates, which are primarily due to breakage of solder connections between the circuit board and the connector.

The reliability of the solder connections between a circuit board and a surface mount connector can be greatly improved by bonding the connector body to the circuit board. However, bonding of the connector body to the circuit board requires additional manufacturing process steps such as underfilling and/or overmolding.

It would be desirable to achieve the improved reliability associated with underfilling and/or overmolding without the additional manufacturing steps required for underfilling and/or overmolding.

### Summary of the Invention

The invention achieves an objective of reliably and durably mounting a connector body to a surface of a circuit board without utilizing conventional underfilling and/or overmolding steps.

In accordance with an aspect of the invention, a process for securing a connector body to a circuit board utilizing a preformed solid mass of adhesive material is provided. The process includes steps of providing the preformed solid mass of adhesive material with a predefined pattern of openings corresponding with a pattern of solder balls on a mounting surface of the connector body. The preformed solid mass of adhesive material is positioned on the mounting surface of the connector body with the openings aligned with the solder balls so that the solder balls project into the openings. The resulting subassembly is positioned on the circuit board with the solder balls aligned with a pattern of contact pads on the circuit board, and with the preformed solid mass of adhesive material disposed between the circuit board and the mounting surface of the connector body. Thereafter, the preformed solid mass of adhesive material is activated to cause it to securely adhere the connector pin carrier to the circuit board.

In accordance with another aspect of the invention, a process for securing a connector body to a circuit board using a liquid adhesive material is provided. The liquid adhesive material is applied to the mounting surface of the connector body, with the liquid adhesive being applied in a pattern that surrounds solder balls on the mounting surface of the connector body. The liquid adhesive is then partially cured to form a subassembly in which the liquid adhesive is converted to a solid adhesive material. The subassembly is positioned on a circuit board with the solder balls aligned with a pattern of contact pads on the circuit board, and with the solid adhesive material disposed between the circuit board and the mounting surface of the connector body. Thereafter, the adhesive is activated to cause it to securely adhere the connector body to the circuit board.

In accordance with another aspect of the invention, a self-adhering connector subassembly is provided. The self-adhering connector subassembly includes a connector body having a mounting surface and a pattern of solder balls on the mounting surface, and an activatable solid adhesive disposed on the mounting surface of the connector body, with the activatable solid adhesive having a pattern of openings into which the solder balls project from the mounting surface.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a cross-sectional view of a connector body mounted to the surface of a circuit board.
FIG. 2 is a cross-sectional view of a self-adhering connector subassembly in accordance with the invention.
FIG. 3 is a bottom view of the self-adhering connector subassembly shown in FIG. 2.

### Description of the Preferred Embodiments

This invention provides a process and subassembly 30 for securely attaching a connector body 12 to the surface of a circuit board. The processes of this invention involve preparation of a self-adhering connector subassembly comprising a connector body having a mounting surface, and a solid adhesive disposed on the mounting surface, positioning of the subassembly on the surface of a circuit board, and activation of the solid adhesive to securely attach the connector body to the circuit board.

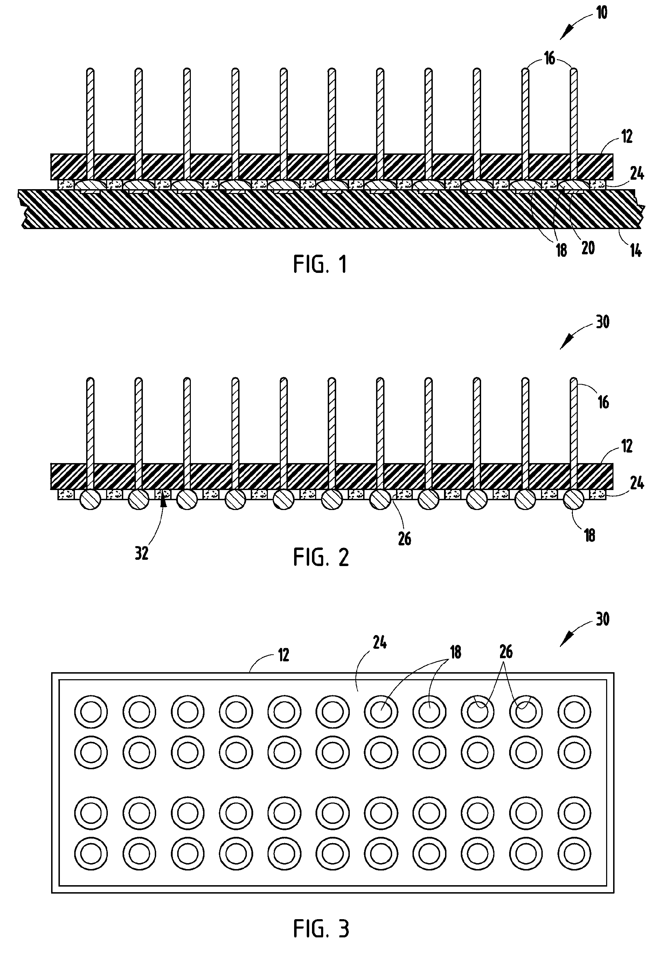

The connector body may comprise a pin carrier 12 holding a plurality of pins 16, as shown in FIG. 1, or a socket carrier (not shown) holding a plurality of sockets that receive connector pins.

The circuit board can be generally any suitable substrate on which electrically conductive pathways or traces can be defined and on which electrical components may be mounted and electrically connected to the conductive pathways or traces to define electrical circuitry. However, the invention is particularly beneficial for use with circuit boards defined on a ceramic substrate, such as a low temperature cofired ceramic (LTCC) substrate, wherein there is a larger difference or mismatch between the coefficient of thermal expansion of the substrate and the connector body.

The expressions "solid mass of adhesive material" and "solid adhesive material" as used to describe and claim the adhesive material disposed on the self-adhering connector assemblies of this invention refers to a material that will not run or flow from the mounting surface of the connector body under the influence of gravity at normal ambient conditions or due to ordinary handling. It does not mean that the adhesive material is necessarily completely devoid of liquid, or that it cannot be caused to liquefy or melt under conditions different from normal ambient conditions. To the contrary, in accordance with certain embodiments of this invention, the solid adhesive is a thermoplastic polymer material that is heated to at least its softening temperature and/or melting temperature to wet the surface of the circuit board, and subsequently cooled to resolidify the adhesive material and form a reliable and durable bond between the connector body and the circuit board.

The term "solder ball" as used herein encompasses solder bumps, solder columns, and the like which are used for mechanically and electrically connecting a surface mount device to a substrate, and is not limited to spherically-shaped solder masses.

The step of activating the activatable solid adhesive disposed on the mounting surface of the connector body refers to a step in which properties of the solid adhesive are modified to induce tackiness of the adhesive material and/or promote wetting of the circuit board and/or subsequent adhesion with the circuit board. In the case of hot-melt adhesives, activation generally refers to melting and/or softening of the adhesive material to form a pliable or deformable mass of material after it is brought into contact with the circuit board, followed by cooling and resolidification of the adhesive to bond the connector body to the circuit board. In the case of thermosettable adhesive compositions, activation may refer to heating or any other activation step which induces chemical cross-linking of polymers or prepolymers in the adhesive composition.

Shown in FIG. 1 is an electrical device 10 comprising a circuit board 14 on which electrical devices (not shown) are typically mounted and a connector body 12. In the illustrated embodiment, the connector body is a pin carrier 12 on which is held a plurality of connector pins 16, which project upwardly away from the circuit board 14. Pins 16 are electrically connected to contact pads 20 on circuit board 14 by solder balls 18. Disposed between pin carrier 12 and circuit board 14 is an adhesive 24 for bonding pin carrier 12 to circuit board 14. A conventional technique for making an electrical device 10 involves first soldering the connector body to circuit board 14, and subsequently underfilling the space between the connector body and the circuit board with an adhesive, typically an epoxy resin. The invention in accordance with one aspect thereof provides an improved process for preparing an electrical device 10 as shown in FIG. 1, which does not involve an underfilling step, and which allows the connector body and adhesive to be provided together as a subassembly 30. In addition to eliminating an underfilling step, the invention also eliminates the need for underfilling apparatus at the facility at which the electrical device 10 is assembled.

As shown in FIGs. 2 and 3, the processes of this invention utilize a self adhering connector subassembly comprising a connector body 12 having a mounting surface 32. The mounting surface has a plurality of solder balls 18 which are used to attach connector body 12 to a circuit board using a solder reflow technique (of the type generally employed for mechanically and electrically connecting a ball grid array to a substrate).

Adhesive 24 may be preformed and provided with a plurality of openings 26 arranged in a pattern corresponding with the solder ball pattern on connector body 12. Preferably, openings 26 have a diameter that is greater than the diameter of solder balls 18.

As an alternative, adhesive 24 may be applied as a liquid, such as by utilizing an ink jet printing technique, to define an adhesive layer 24 having openings 26.

Suitable hot-melt adhesive compositions that may be employed, and that can be activated (e.g., softened or melted) to develop tackiness and/or bond to a surface, and subsequently solidify to reliably and durably attach connector body 12 to circuit board 14 include polyolefins, polyamides, ethylene-propylene copolymers, styrene-butadiene copolymers, ethylene-propene copolymers, ethylene-vinyl acetate copolymers, and the like.

Suitable thermosettable adhesive compositions include epoxy resins, phenolic resins, and polyimides. Preferred thermosettable resin compositions include partially cross-linked polymer compositions (e.g., so-called B-stage resins).

The thermosettable resins are typically heat activatable, although it is conceivable that other activating techniques may be employed, such as activation by electromagnetic radiation.

In order to improve heat dissipation, it may be desirable to utilize an adhesive material which comprises a thermally conductive particle filler such as carbon black, alumina or zinc oxide, in an amount sufficient to provide a thermal conductivity in the range from about 0.5 to about 1.0 w/M-K.

While it is conceivable that activation of the adhesive and solder reflow may be achieved in separate steps, it is preferable that solder reflow and activation of the adhesive material occurs concurrently upon application of heat to the device 10 after subassembly 30 has been properly positioned on the circuit board with solder balls 18 properly aligned with contact pads 20. Such heating can be achieved in an oven or by use of infrared radiation.

The invention provides a product that exhibits decreased sensitivity to handling damage, lower transmitted forces to the solder joints during connector engagement and disengagement, and lower stresses during temperature excursions. These advantages provide increased component solder joint reliability and durability. Application of the adhesive to the connector body prior to mounting the connector body on the circuit board results in savings in the production process, such as by eliminating underfill manufacturing processes. Because the adhesive joint may be formed during the solder reflow process, additional curing process steps may be eliminated.

It will be understood by those who practice the invention and those skilled in the art that various modifications and improvements may be made to the invention without departing from the spirit of the disclosed concept. The scope of protection afforded is to be determined by the claims and by the breadth of interpretation allowed by law.

## Claims

1. A process for securing a connector body to a circuit board, comprising:
providing a preformed solid mass of adhesive material having a predefined pattern of openings corresponding with the pattern of solder balls on a mounting surface of a connector body;
positioning the preformed solid mass of adhesive material on the mounting surface of the connector body with the openings of the preformed solid mass of adhesive material aligned with the solder balls so that the solder balls project into the openings, the connector body and adhesive material defining a subassembly;
positioning the subassembly on a circuit board with the solder balls aligned with a pattern of contact pads on a circuit board, and with the preformed solid mass of adhesive material disposed between the circuit board and the mounting surface of the connector body; and
activating the preformed solid mass of adhesive material to cause it to securely adhere the connector body to the circuit board.

2. The process of claim 1, wherein activating of the preformed solid mass of adhesive material comprises heating the preformed solid mass of adhesive material to form a deformable mass of material that adheres to the circuit board, and subsequently allowing the deformable mass of material to solidify and securely bond the connector body to the circuit board.

3. The process of claim 2, wherein heating of the preformed solid mass of adhesive material occurs during reflow of the solder balls, whereby adhesive bonding of the connector body to the circuit board and soldering of the connector body to the circuit board occurs substantially concurrently.

4. The process of claim 1, wherein the adhesive material comprises a thermoplastic polymer that is capable of becoming deformable upon heating the polymer to a temperature at or above its softening point temperature, and which solidifies to securely bond the connector body to the circuit board upon cooling to ambient temperature.

5. The process of claim 1, wherein the adhesive material is a partially cross-linked polymer composition that undergoes further cross-linking upon application of heat.

6. The process of claim 4, wherein the thermoplastic polymer is selected from the group consisting of polyolefins, polyamides, ethylene-propylene copolymers, styrene-butadiene copolymers, ethylene-propene copolymers, and ethylene-vinyl acetate copolymers.

7. The process of claim 5, wherein the partially cross-linked polymer composition is selected from the group consisting of epoxy resins, phenolic resins, and polyimides.

8. The process of claim 1, wherein the mass of adhesive material contains a thermally conductive particle filler.

9. The process of claim 8, wherein the thermally conductive particle filler is selected from the group consisting of carbon black, alumina, and zinc oxide, and is present in an amount sufficient to achieve a thermal conductivity of from about 0.5 to about 1.0 w/M-K for the adhesive material.

10. A process for securing a connector body to a circuit board, comprising:
providing a connector body having a pattern of solder balls on a mounting surface of the connector body;
applying a liquid adhesive material to the mounting surface of the connector body in a pattern that surrounds the solder balls;
partially curing the liquid adhesive material to form a subassembly in which the liquid adhesive is converted to a solid adhesive material;
positioning the subassembly on a circuit board with the solder balls aligned with a pattern of contact pads on the circuit board and with the solid adhesive material disposed between the circuit board and the mounting surface of the connector body; and
activating the preformed solid mass of adhesive material to cause it to securely adhere the connector body to the circuit board.

11. The process of claim 10, wherein activating of the preformed solid mass of adhesive material comprises heating the preformed solid mass of adhesive material to form a deformable mass of material that adheres to the circuit board, and subsequently allowing the deformable mass of material to solidify and securely bond the connector body to the circuit board.

12. The process of claim 11, wherein heating of the preformed solid mass of adhesive material occurs during reflow of the solder balls, whereby adhesive bonding of the connector body to the circuit board and soldering of the connector body to the circuit board occurs substantially concurrently.

13. The process of claim 10, wherein the adhesive material comprises a thermoplastic polymer that is capable of becoming deformable upon heating the polymer to a temperature at or above its softening point temperature, and which solidifies to securely bond the connector body to the circuit board upon cooling to ambient temperature.

14. The process of claim 10, wherein the adhesive material is a partially cross-linked polymer composition that undergoes further cross-linking upon application of heat.

15. The process of claim 13, wherein the thermoplastic polymer is selected from the group consisting of polyolefins, polyamides, ethylene-propylene copolymers, styrene-butadiene copolymers, ethylene-propene copolymers, and ethylene-vinyl acetate copolymers.

16. The process of claim 14, wherein the partially cross-linked polymer composition is selected from the group consisting of epoxy resins, phenolic resins, and polyimides.

17. The process of claim 10, wherein the mass of adhesive material contains a thermally conductive particle filler.

18. The process of claim 17, wherein the thermally conductive particle filler is selected from the group consisting of carbon black, alumina, and zinc oxide, and is present in an amount sufficient to achieve a thermal conductivity of from about 0.5 to about 1.0 w/M-K for the adhesive material.

19. A self-adhering connector subassembly, comprising:
a connector body having a mounting surface and a pattern of solder balls on the mounting surface; and
an activatable solid adhesive disposed on the mounting surface of the connector body, the activatable solid adhesive having a pattern of openings in which the solder balls project.
